# DEMANDE DE BREVET EUROPEEN

(11) **EP 4 195 246 A1**
(43) Date de publication de la demande: **14.06.2023**
(21) Numéro de dépôt: 22210558.7
(22) Date de dépôt: 30.11.2022
(51) Int. Cl.: H01L 21/768, H01L 23/48

(54) **PROCÉDÉ DE FABRICATION D'UN VIA**

(30) Priorité: 07.12.2021 GR 20210100851; 10.01.2022 FR 2200140
(71) Demandeur: STMicroelectronics Crolles 2 SAS, 38920 Crolles (FR)
(72) Inventeur: BARLAS, Marios, 38000 GRENOBLE (FR); GOURAUD, Pascal, 38330 MONTBONNOT ST MARTIN (FR)
(74) Mandataire: Cabinet Beaumont

(57) **Abrégé**

La présente description concerne un procédé de fabrication d'un vias conducteur isolé (36) traversant un premier empilement (10') de couches (14, 18) de manière à atteindre une première couche (12), le premier empilement comprenant au moins une deuxième couche conductrice ou semiconductrice (14), le procédé comprenant :
a) la formation d'une première cavité dans le premier empilement ;
b) la formation d'un deuxième empilement (22) comprenant une troisième couche d'arrêt de gravure (26), et d'une quatrième couche isolante (28) sur les parois et le fond de la première cavité ;
c) la gravure d'une deuxième cavité (34) traversant les premier et deuxième empilements ;
d) la formation d'une cinquième couche (36) isolante recouvrant le fond de la deuxième cavité ; et
e) la gravure anisotrope de la cinquième couche, la gravure étant une gravure sélective du matériau de la cinquième couche par rapport à la troisième couche.

## Description

### Domaine technique

La présente description concerne de façon générale les dispositifs électroniques et leurs procédés de fabrication, et plus précisément les vias et leurs procédés de fabrication.

### Technique antérieure

La fabrication de vias, et en particulier de vias conducteurs, est un élément présent dans la majeure partie des procédés de fabrication de dispositifs électroniques.

Les dispositifs électroniques ont des dimensions de plus en plus petites. Cela entraine un besoin pour des vias plus petits et donc des procédés de fabrication plus précis.

### Résumé de l'invention

Un mode de réalisation pallie tout ou partie des inconvénients des procédés de fabrication de vias connus.

Un mode de réalisation prévoit un procédé de fabrication d'un via conducteur isolé traversant un premier empilement de couches de manière à atteindre une première couche, le premier empilement comprenant au moins une deuxième couche conductrice ou semiconductrice, le procédé comprenant a) la formation d'une première cavité dans le premier empilement, la première cavité traversant partiellement la deuxième couche ; b) la formation d'un deuxième empilement comprenant une troisième couche d'arrêt de gravure recouverte d'une quatrième couche isolante sur la face supérieure du premier empilement et sur les parois et le fond de la première cavité ; c) la gravure d'une deuxième cavité traversant les premier et deuxième empilements, la deuxième cavité s'étendant entre le fond de la première cavité et la première couche ; d) la formation d'une cinquième couche isolante recouvrant le deuxième empilement et les parois et le fond de la deuxième cavité ; e) la gravure anisotrope de la cinquième couche de manière à former une gaine isolante du via sur les parois de la deuxième cavité, la gravure étant une gravure sélective du matériau de la cinquième couche par rapport au matériau de la troisième couche ; et f) le remplissage de la deuxième cavité par un matériau conducteur de manière à former un cœur conducteur du via.

Selon un mode de réalisation, l'étape f) comprend aussi le remplissage de la première cavité par le matériau conducteur.

Selon un mode de réalisation, la première couche est conductrice ou semiconductrice.

Selon un mode de réalisation, l'étape c) comprend une photolithographie.

Selon un mode de réalisation, le matériau de la quatrième couche et le matériau de la cinquième couche sont gravables sélectivement par rapport au matériau de la première couche.

Selon un mode de réalisation, les quatrième et cinquième couches sont en oxyde de silicium et la deuxième couche est en silicium.

Selon un mode de réalisation, le procédé comprend, entre les étapes e) et f), une étape de retrait de la troisième couche.

Selon un mode de réalisation, la troisième couche est en un matériau gravable sélectivement par rapport au matériau de la première couche.

Selon un mode de réalisation, la troisième couche est en carbone amorphe.

Selon un mode de réalisation, le premier empilement a une épaisseur supérieure ou égale à 6 µm.

Selon un mode de réalisation, le premier empilement comprend au moins une sixième couche isolante entre la première couche et la deuxième couche.

Selon un mode de réalisation, le deuxième empilement comprend une septième couche isolante située entre la troisième couche et le premier empilement.

Selon un mode de réalisation, le matériau de la troisième couche est gravable de manière sélective par rapport à la septième couche.

Selon un mode de réalisation, le premier empilement comprend au moins une huitième couche située entre la deuxième couche et le deuxième empilement.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente une étape d'un procédé de fabrication d'un via ;
la figure 2 représente une autre étape d'un procédé de fabrication d'un via ;
la figure 3 représente une autre étape d'un procédé de fabrication d'un via ;
la figure 4 représente une autre étape d'un procédé de fabrication d'un via ;
la figure 5 représente une autre étape d'un procédé de fabrication d'un via ;
la figure 6 représente une autre étape d'un procédé de fabrication d'un via ;
la figure 7 représente une autre étape d'un procédé de fabrication d'un via ; et
la figure 8 représente une autre étape d'un procédé de fabrication d'un via.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Sauf précision contraire, les termes "isolant" ou "conducteur" sont à comprendre comme "isolant électriquement" et "conducteur électriquement".

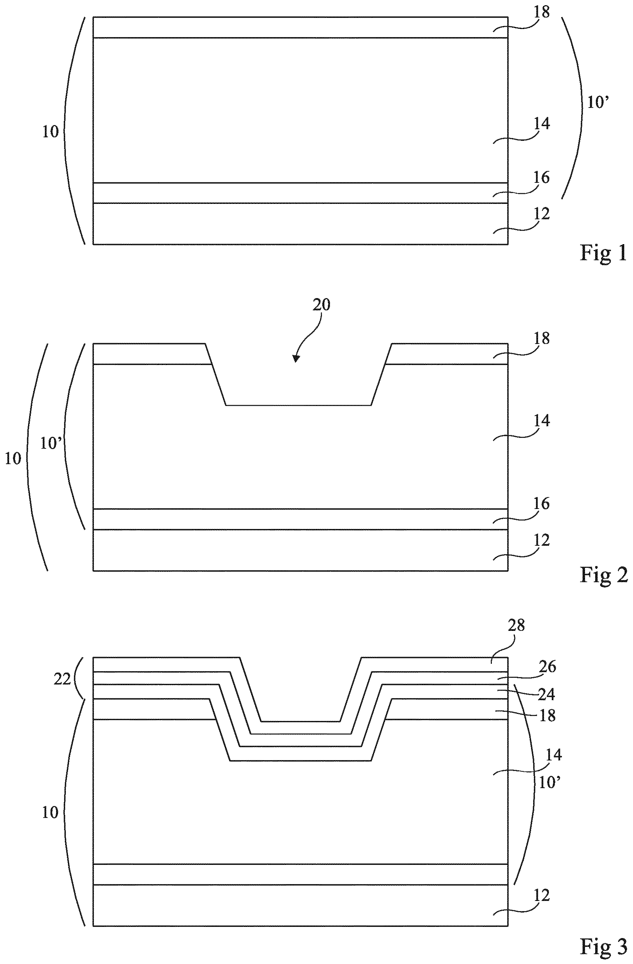

Les figures 1 à 9 représentent des étapes de préférence successives d'un procédé de fabrication d'un via, ou d'un plot de connexion, de préférence un via conducteur, dans au moins une couche conductrice. Le via formé par le procédé est un via isolé, comprenant donc une gaine isolante et un cœur conducteur.

La figure 1 représente une étape d'un procédé de fabrication d'un via, de préférence un via conducteur.

Au cours de cette étape, un empilement 10 est formé. L'empilement 10 comprend une couche inférieure 12 et un empilement 10' reposant sur la couche 12. L'empilement 10' correspond aux couches traversées par le via, de manière à permettre au via d'atteindre la couche 12. L'empilement 10' est ainsi en contact avec la couche 12 à l'emplacement de formation du via. L'empilement 10' a par exemple une épaisseur supérieure ou égale à 6 µm.

La couche 12 est par exemple une couche conductrice ou semiconductrice. La couche 12 est de préférence une couche conductrice, de préférence une couche métallique, par exemple en cuivre.

L'empilement 10' comprend au moins une couche 14 conductrice ou semiconductrice. La couche 14 est de préférence une couche semiconductrice, par exemple une couche en silicium. La couche 14 repose sur la couche 12.

Dans l'exemple de la figure 1, l'empilement 10' comprend une couche inférieure 16. La couche 16 est la couche de l'empilement 10' la plus proche de la couche 12. La couche 16 est, dans l'exemple de la figure 1, en contact avec la couche 12. La couche 16 est de préférence en un matériau isolant.

Dans l'exemple de la figure 1, l'empilement 10' comprend une couche supérieure 18. La couche 18 est la couche de l'empilement 10' la plus éloignée de la couche 12. La face supérieure de la couche 18 correspond donc à la face supérieure de l'empilement 10' et de l'empilement 10, c'est-à-dire la face la plus éloignée de la couche 12. La couche 18 est, dans l'exemple de la figure 1, en contact avec la couche 14. La couche 16 est par exemple en un matériau isolant ou en un matériau conducteur ou semiconducteur.

L'empilement 10' peut par exemple comprendre une ou plusieurs couches non représentées situées entre la couche 16 et la couche 14. L'empilement 10' peut par exemple comprendre une ou plusieurs couches non représentées situées entre la couche 18 et la couche 14. Selon un autre mode de réalisation, l'empilement 10' ne comprend que la couche 14.

La figure 2 représente une autre étape d'un procédé de fabrication d'un via.

Au cours de cette étape, une cavité 20 est formée dans l'empilement 10' à l'emplacement prévu du via. La cavité 20 est par exemple formée par une étape de photolithographie.

La cavité 20 s'étend de la face supérieure de l'empilement 10 jusqu'à la couche 14. De préférence, la cavité 20 s'étend partiellement dans la couche 14. Autrement dit, la cavité 20 traverse la couches 18 et s'étend dans la couche 14. Le fond de la cavité 20 est situé dans la couche 14. Le fond de la cavité 20 est séparé de la couche 12 par une portion de la couche 14.

Les dimensions du fond de la cavité 20 sont supérieures aux dimensions, dans le plan du fond de la cavité 20, voulues du via.

La figure 3 représente une autre étape d'un procédé de fabrication d'un via.

Au cours de cette étape, un empilement 22 de couches est formé sur la structure résultant de l'étape de la figure 2, c'est-à-dire que les couches de l'empilement 22 sont par exemple formés successivement sur la structure résultant de l'étape de la figure 2. Autrement dit, l'empilement 22 recouvre la face supérieure de l'empilement 10' et les parois et le fond de la cavité 20. L'empilement 22 comprend, dans l'exemple de la figure 3, des couches 24, 26 et 28.

La couche 24 est une couche isolante électriquement, par exemple en un oxyde, par exemple en oxyde de silicium. La couche 24 est la couche inférieure de l'empilement 22, c'est-à-dire la couche la plus proche de la couche 12. La couche 24 est en contact avec la face supérieure de l'empilement 10', avec les parois de la cavité 20 et avec le fond de la cavité 20.

La couche 26, constituant la couche intermédiaire de l'empilement 22, recouvre, de préférence entièrement, la couche 24. La couche 26 recouvre la couche 24 au moins dans la cavité 20.

La couche 28, constituant la couche supérieure de l'empilement 22, c'est-à-dire la couche la plus éloignée de la couche 12, recouvre, de préférence entièrement, la couche 26. La couche 28 recouvre la couche 26 au moins dans la cavité 20. La couche 26 est ainsi située entre les couches 24 et 28. La couche 28 est une couche isolante électriquement, par exemple en le même matériau que la couche 24. La couche 28 permet de protéger la couche 26.

La couche 26 est en un matériau pouvant être gravé sélectivement par rapport au matériau de la couche 12. Autrement dit, il existe un procédé de gravure gravant le matériau de la couche 26 au moins deux fois plus vite que le matériau de la couche 12. Le matériau de la couche 26 est aussi gravable sélectivement par rapport au matériau de la couche 24. Autrement dit, il existe un procédé de gravure gravant le matériau de la couche 26 au moins deux fois plus vite que le matériau de la couche 24. De plus, le matériau de la couche 14 peut être gravé sélectivement par rapport au matériau de la couche 28. Autrement dit, il existe un procédé de gravure gravant le matériau de la couche 14 au moins deux fois plus vite que le matériau de la couche 28. Le matériau de la couche 28 peut être gravé sélectivement par rapport aux matériaux des couches 12 et 26. Autrement dit, il existe un procédé de gravure gravant le matériau de la couche 28 au moins deux fois plus vite que les matériaux des couches 12 et 26. La couche 26 est par exemple en carbone amorphe.

De manière plus générale, l'empilement 22 comprend au moins la couche 26 et la couche 28. La couche 24 peut ne pas être présente.

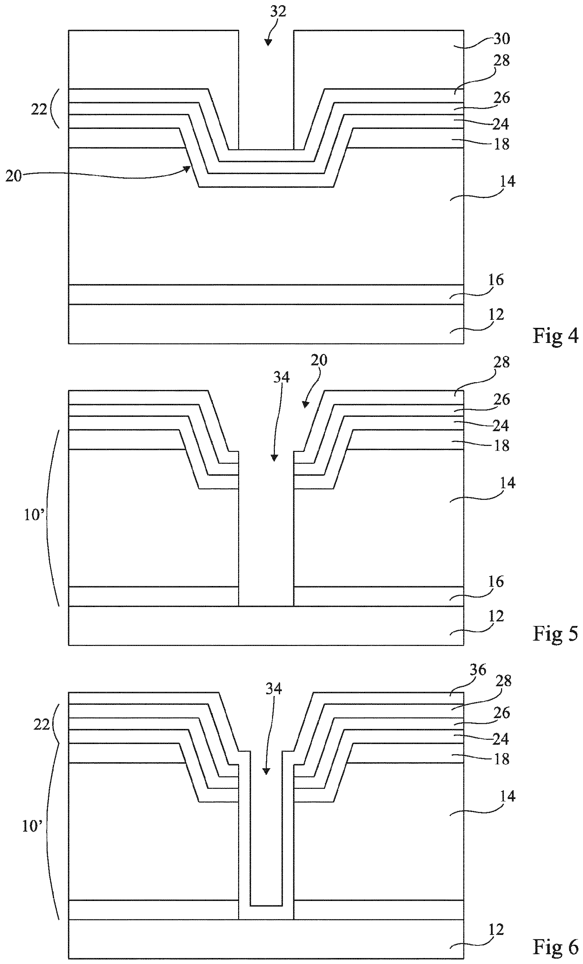

La figure 4 représente une autre étape d'un procédé de fabrication d'un via.

Au cours de cette étape, un masque 30 de photolithographie est formé sur la structure résultant de l'étape de la figure 3. Le masque 30 est par exemple en résine.

Le masque 30 comprend une ouverture 32 au niveau de la cavité 20. L'ouverture traverse le masque 30 de manière à atteindre le fond de la cavité 20. Autrement dit, l'ouverture 32 découvre partiellement le fond de la cavité 20. Les dimensions de l'ouverture 32 dans le plan du fond de la cavité 20 sont inférieures aux dimensions du fond de la cavité 20.

La figure 5 représente une autre étape d'un procédé de fabrication d'un via.

L'étape de la figure 5 comprend la gravure de l'empilement 22 au travers de l'ouverture 32. Cette étape de gravure entraine également la gravure au moins partielle du masque de résine 30.

L'étape de la figure 5 comprend ensuite la gravure, à travers l'ouverture 32, de l'empilement de la portion de l'empilement 10' situé en regard de l'ouverture 32. Cette étape de gravure forme une cavité 34 dans les empilements 22 et 10'. La cavité 34 atteint la couche 12 et découvre donc la portion de la couche 12 en regard de l'ouverture 32.

La gravure de la couche 14 retire de préférence le reste du masque 30. La gravure de la couche 14 peut entrainer la gravure partielle de la couche 28. L'épaisseur de la couche 28 et l'épaisseur du masque 30 sont de préférence choisis de telle manière que la couche 26 soit entièrement recouverte par la couche 28 après la gravure de l'empilement 10'. La couche 26 n'est donc de préférence pas découverte lors de la gravure de l'empilement 10'.

La figure 6 représente une autre étape d'un procédé de fabrication d'un via.

Au cours de cette étape, une couche isolante 36 est formée sur la structure résultant de l'étape de la figure 5. La couche 36 est en le même matériau que la couche 28.

La couche 36 recouvre la structure de manière conforme. Autrement dit, la couche 36 recouvre la face supérieure de la couche 28, et les parois et le fond de la cavité 34.

Les portions de la couche 36 situées sur les parois de la cavité 34 sont destinées à former la gaine du via, c'est-à-dire à isoler le via conducteur des couches de l'empilement 10', en particulier de la couche 14. L'épaisseur de la couche 36 n'est donc pas suffisante pour remplir entièrement la cavité 34.

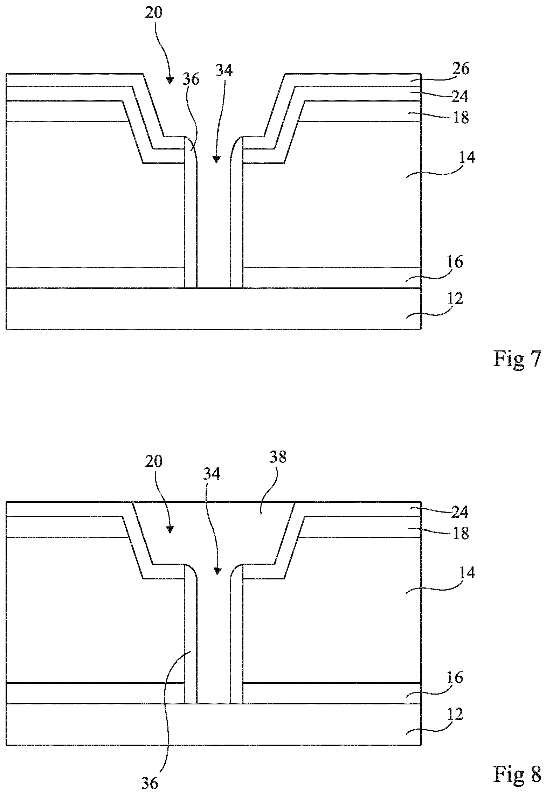

La figure 7 représente une autre étape d'un procédé de fabrication d'un via.

Cette étape comprend une gravure anisotrope des couches 28 et 36. Ainsi, les portions des couches 28 et 36 situées sur la couche 26 sont gravées. La portion de la couche 36 située au fond de la cavité 34, c'est-à-dire en contact avec la couche 12, est gravée. Ainsi, la couche 12 est découverte. De même, la couche 26 est découverte. De préférence, la face supérieure de la couche 26 est entièrement découverte. Les portions de la couche 36 situées sur les parois de la cavité 34 ne sont pas retirées. En particulier, les parois latérales de la couche 14 sont séparées de la cavité 34 par les portions de la couche 36.

La gravure est une gravure sélective du matériau des couches 28 et 36. La gravure est donc telle que les matériaux des couches 26 et 12 ne sont pas gravés pendant la gravure des couches 28 et 36. La couche 26 protège donc les portions de l'empilement 10 sur lesquelles elle est située pendant la gravure des couches 28 et 36 et assure que l'on peut retirer entièrement la couche 28 et les portions de la couche 36 n'étant pas sur les parois latérales de la cavité 34.

La figure 8 représente une autre étape d'un procédé de fabrication d'un via.

Au cours de cette étape, la couche 26 est gravée, par exemple par un plasma oxygène ou hydrogène. Le matériau de la couche 26 pouvant être gravé sélectivement par rapport aux matériaux de la couche 24 et de la couche 12, la couche 24 et la couche 12 ne sont pas gravées, ou détruite, lors de cette étape.

De plus, le cœur conducteur 38 du via est formé. Le cœur 38 remplit par exemple entièrement la cavité 34 et la cavité 20. Le cœur s'étend de préférence de la couche 12 jusqu'au niveau de la face supérieure de la couche 24. Le cœur 38 est ainsi en contact avec la couche 12 par sa face inférieure.

Le cœur 38 est par exemple formé par un procédé Damascène, c'est-à-dire le dépôt d'une couche du matériau du cœur, la couche ayant une épaisseur suffisante pour remplir les cavités 20 et 34, et le polissage mécano-chimique de ladite couche de manière la retirer en dehors des cavités 20 et 34. Le polissage mécanochimique est par exemple un procédé permettant de graver sélectivement le matériau du cœur 38 par rapport aux couches 18 et 24.

A titre de variante, le cœur peut remplir entièrement la cavité 34 mais ne pas remplir la cavité 20 entièrement. Par exemple, des parties périphériques de la cavité 20 peuvent ne pas être remplies par le cœur 38.

On aurait pu choisir de former le via sans former l'empilement 22. Il aurait alors été nécessaire d'ajouter une étape de photolithographie de manière à retirer la portion de la couche 36 située au fond de la cavité 36. Les dimensions latérales de la cavité 34 auraient alors dû être suffisamment importantes pour permettre la formation du masque de photolithographie.

Un avantage des modes de réalisation décrits est qu'ils permettent de mieux contrôler le rapport de forme des vias, en particulier de former des vias de dimensions horizontales plus petites et de former des vias plus profonds.

Un autre avantage des modes de réalisation décrits est qu'ils nécessitent un nombre inférieur d'étapes, en particulier un nombre inférieur d'étapes de photolithographie.

Un autre avantage des modes de réalisation décrits est que les vias sont autoalignés avec la piste de connexion. Cela permet, lors de la fabrication d'un réseau d'interconnexion, de diminuer les dimensions dudit réseau.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de fabrication d'un vias conducteur isolé (36, 38) traversant un premier empilement (10') de couches (14, 16, 18) de manière à atteindre une première couche (12), le premier empilement comprenant au moins une deuxième couche conductrice ou semiconductrice (14), le procédé comprenant :
a) la formation d'une première cavité (20) dans le premier empilement (10'), la première cavité (20) traversant partiellement la deuxième couche (14) ;
b) la formation d'un deuxième empilement (22) comprenant une troisième couche d'arrêt de gravure (26) recouverte d'une quatrième couche isolante (28) sur la face supérieure du premier empilement (10') et sur les parois et le fond de la première cavité (20) ;
c) la gravure d'une deuxième cavité (34) traversant les premier (10') et deuxième (22) empilements, la deuxième cavité s'étendant entre le fond de la première cavité (20) et la première couche (12) ;
d) la formation d'une cinquième couche (36) isolante recouvrant le deuxième empilement (22) et les parois et le fond de la deuxième cavité (34) ;
e) la gravure anisotrope de la cinquième couche (36) de manière à former une gaine isolante du via sur les parois de la deuxième cavité (34), la gravure étant une gravure sélective du matériau de la cinquième couche (36) par rapport au matériau de la troisième couche (26) ; et
f) le remplissage de la deuxième cavité (34) par un matériau conducteur de manière à former un cœur conducteur du via.

2. Procédé selon la revendication 1, dans lequel l'étape f) comprend aussi le remplissage de la première cavité (20) par le matériau conducteur.

3. Procédé selon la revendication 1 ou 2, dans lequel la première couche (12) est conductrice ou semiconductrice.

4. Procédé selon l'une quelconque des revendications 1 à 3, dans lequel l'étape c) comprend une photolithographie.

5. Procédé selon l'une quelconque des revendications 1 à 4, dans lequel le matériau de la quatrième couche (28) et le matériau de la cinquième couche (36) sont gravables sélectivement par rapport au matériau de la première couche (12) .

6. Procédé selon l'une quelconque des revendications 1 à 5, dans lequel les quatrième et cinquième couches sont en oxyde de silicium et la deuxième couche est en silicium.

7. Procédé selon l'une quelconque des revendications 1 à 6, comprenant, entre les étapes e) et f), une étape de retrait de la troisième couche (26).

8. Procédé selon l'une quelconque des revendications 1 à 7, dans lequel la troisième couche (26) est en un matériau gravable sélectivement par rapport au matériau de la première couche (12).

9. Procédé selon l'une quelconque des revendications 1 à 8, dans lequel la troisième couche (26) est en carbone amorphe.

10. Procédé selon l'une quelconque des revendications 1 à 9, dans lequel le premier empilement (10') a une épaisseur supérieure ou égale à 6 µm.

11. Procédé selon l'une quelconque des revendications 1 à 10, dans lequel le premier empilement (10') comprend au moins une sixième couche isolante (16) entre la première couche (12) et la deuxième couche (14).

12. Procédé selon l'une quelconque des revendications 1 à 11, dans lequel le deuxième empilement (22) comprend une septième couche isolante (24) située entre la troisième couche (26) et le premier empilement (10').

13. Procédé selon la revendication 12, dans lequel le matériau de la troisième couche (26) est gravable de manière sélective par rapport à la septième couche (24).

14. Procédé selon l'une quelconque des revendications 1 à 13, dans lequel le premier empilement (10') comprend au moins une huitième couche (18) située entre la deuxième couche (14) et le deuxième empilement (22).
